# FASCICULE DE BREVET EUROPEEN

(11) **EP 4 397 147 B1**
(45) Date de publication et mention de la délivrance du brevet: **30.09.2026**
(21) Numéro de dépôt: 22769325.6
(22) Date de dépôt: 21.08.2022
(51) Int. Cl.: H05K 7/14, H02M 7/00

(54) **FILTRE DE TENSION CONTINUE POUR UNE ENTREE D'ONDULEUR D'UNE MACHINE ELECTRIQUE DE PROPULSION D'UN AERONEF**
GLEICHSPANNUNGSFILTER FÜR EINEN WANDLEREINGANG EINER ELEKTRISCHEN FLUGZEUG-ANTRIEBSMASCHINE
DC VOLTAGE FILTER FOR AN INVERTER INPUT OF AN ELECTRIC AIRCRAFT MOTOR

(30) Priorité: 31.08.2021 FR 2109101
(43) Date de publication de la demande: 10.07.2024
(73) Titulaire: Safran Electrical & Power, 31702 Blagnac Cedex (FR)
(72) Inventeur: NEHME, Samir, 77550 MOISSY-CRAMAYEL (FR); DHOKKAR, Sonia, 77550 MOISSY-CRAMAYEL (FR); GONCALVES, Rémi, 77550 MOISSY-CRAMAYEL (FR); M'FUMU AMBIL, Raïs, 77550 MOISSY-CRAMAYEL (FR); SOUAHLIA, Rachid, 77550 MOISSY-CRAMAYEL (FR); DIEVART, Jean-Laurent, 77550 MOISSY-CRAMAYEL (FR); THIAM, Abdoulahad, 77550 MOISSY-CRAMAYEL (FR)
(74) Mandataire: Gevers & Orès
(86) Numéro de dépôt international: PCT/FR2022/051592
(87) Numéro de publication internationale: WO 2023/031534

(56) Documents cités:
- EP-B1- 1 418 660
- GB-A- 2 242 580
- US-A1- 2010 327 680
- US-A1- 2012 274 158
- US-A1- 2020 343 824
- US-B1- 10 717 366
- US-B2- 9 620 292

## Description

### Domaine technique de l'invention

La présente invention concerne un filtre de tension continue pour une entrée d'onduleur d'une machine électrique de propulsion d'un aéronef. Elle concerne en outre un convertisseur de tension comportant un tel filtre, une propulsion électrique comportant un tel convertisseur de tension et un aéronef comportant une telle propulsion électrique.

### Arrière-plan technologique

Les avions à propulsion électrique ou hybride, que ce soient des avions conventionnels ou bien à décollage et atterrissage vertical (de l'anglais « Vertical Take-off and Landing ») ou bien encore à décollage et atterrissage court (de l'anglais « Short Take-off and Landing »), constituent un marché avec des perspectives et une demande importante dans le transport intra urbain et inter urbain pour transporter des marchandises ou des personnes.

La propulsion électrique est réalisée par un ou plusieurs moteurs électriques, le nombre variant suivant les architectures.

Généralement la transmission de puissance d'une source de tension continue jusqu'au moteur électrique se fait par un seul onduleur, et ce dernier comporte un filtre d'entrée comportant en particulier une capacité de forte valeur et donc encombrante.

Il peut être souhaité de prévoir un dispositif pouvant être intégré de manière compacte à la machine électrique.

L'état de la technique concernant les moteurs électriques et la capacité du filtre d'entrée comporte les documents US 2020 343824 A1, US 2012 0274158 A1 EP 1 418 660 B1, US 9,620,292 B2 et US 2010 0327680 A1.

Par ailleurs, le document US 10 717 366 B1 décrit un filtre d'entrée conçu pour filtrer une tension continue, comportant :
- une barre omnibus positive et une barre omnibus négative ; et
- des capacités de mode différentiel connectées entre deux portions respectives des barres omnibus ; les deux portions ayant chacune des pliures sensiblement parallèles afin de définir au moins trois plans se succédant l'un après l'autre en étant inclinés l'un par rapport au suivant, pour obtenir une courbure des portions ; l'une des portions, dite interne, étant emboîtée dans l'autre, dite externe, de manière à ce que chaque plan de l'une s'étende sensiblement parallèlement en face d'un plan associé de l'autre.

Le document GB 2 242 580 A divulgue également un filtre d'entrée conçu pour filtrer une tension continue.

### Résumé de l'invention

Il est donc proposé une propulsion électrique selon la revendication 1.

Des caractéristiques optionnelles de cette propulsion électrique sont énoncées dans les revendications 2 à 4.

Il est également proposé un aéronef selon la revendication 5.

### Brève description des figures

L'invention sera mieux comprise à l'aide de la description qui va suivre, donnée uniquement à titre d'exemple et faite en se référant aux dessins annexés dans lesquels :
- la figure 1 est une vue fonctionnelle d'un exemple d'une propulsion électrique selon l'invention d'un aéronef,
- la figure 2 est un schéma électrique d'un exemple de filtre d'entrée d'un convertisseur de tension de la propulsion électrique de la figure 1,
- la figure 3 est une vue en trois dimensions de barres omnibus du filtre d'entrée de la figure 2, séparées l'une de l'autre,
- la figure 4 est une vue en trois dimensions des barres omnibus du filtre d'entrée de la figure 2, assemblées l'une à l'autre,
- la figure 5 est une vue en trois dimensions du filtre d'entrée de la figure 2,
- la figure 6 est une vue en coupe du filtre d'entrée de la figure 2,
- la figure 7 est une vue en trois dimensions d'un exemple d'une partie d'une propulsion électrique selon l'invention d'un aéronef,
- la figure 8 est une vue en trois dimensions de la partie de la propulsion électrique de la figure 7, selon un autre angle de vue, et
- la figure 9 est une vue en coupe de la partie de la propulsion électrique de la figure 7.

### Description détaillée de l'invention

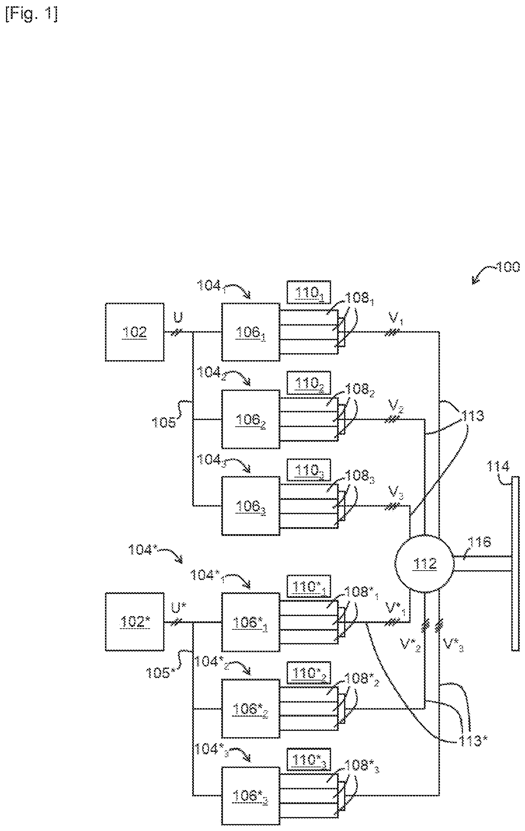

En référence à la figure 1, un exemple d'une propulsion électrique 100 d'un aéronef va à présent être décrit.

La propulsion électrique 100 comporte tout d'abord une source de tension continue 102 conçue pour fournir une tension continue U. La source de tension continue 102 comporte par exemple une ou plusieurs batteries.

La propulsion électrique 100 comporte en outre au moins un onduleur 104₁₋₃ connecté(s) par un harnais de puissance continue 105 à la source de tension continue 102 et conçu pour convertir chacun la tension continue U en une tension alternative V₁₋₃ respective. Chaque tension alternative V₁₋₃ est par exemple une tension polyphasée, notamment triphasée.

Chaque onduleur 104₁₋₃ comporte en particulier un filtre d'entrée 106₁₋₃ et, pour chaque filtre d'entée un ou plusieurs modules de puissance, désignés à chaque fois par la référence globale 108₁₋₃ et conçus pour respectivement fournir la ou les différentes phases de la tension alternative V₁₋₃ à partir de la tension continue U après filtrage par le filtre d'entrée 106₁₋₃. Lorsque la tension alternative V₁₋₃ est triphasée, trois modules de puissance 108₁₋₃ sont par exemple prévus.

Chaque onduleur 104 comporte en outre de l'électronique de commande 110₁₋₃ conçue pour commander les modules de puissance 108₁₋₃.

L'utilisation de plusieurs onduleurs 104 en parallèle permet de réduire la puissance électrique passant par chacun d'eux.

La propulsion électrique 100 comporte en outre un moteur électrique 112 présentant un stator et un rotor (non représentés). Le moteur électrique 112 est par exemple un moteur synchrone à aimant permanent.

Le stator présente des bobinages statoriques (non représentés) électriquement connectées aux modules de puissance 108₁₋₃ par un harnais de puissance polyphasé 113 pour respectivement recevoir les phases des tensions alternatives V₁₋₃. En réponse aux tensions alternatives V₁₋₃, le stator est ainsi conçu pour générer un champ magnétique tournant.

Le rotor, par exemple à aimant permanent, est conçu pour être entraîné en rotation par le champ magnétique tournant, afin d'entraîner par exemple une hélice 114 de la propulsion électrique 100 à laquelle le rotor est mécaniquement connecté par un arbre de sortie 116 de la propulsion électrique 100.

De préférence, comme illustré sur la figure 1, une deuxième voie d'alimentation électrique est prévue avec des éléments similaire à ceux de la première voie. Ces éléments similaires portent les mêmes référence que ceux de la première voie, avec astérisque « * » en plus. Les deux voies sont de préférence indépendantes l'une de l'autre de telle sorte qu'une panne sur l'une des voies ne provoque pas de panne sur l'autre. Ainsi, en cas de perte d'une voie complète, une fourniture minimale par l'autre voie peut être assurée. En particulier, cette deuxième voie comporte de préférence une deuxième source de tension continue 102* (indépendante de la première 102) et des onduleurs 104*₁₋₃.

Ainsi, dans l'exemple illustré, chaque voie comporte trois onduleurs en parallèle pouvant fournir jusqu'à 90 kW de puissance électrique chacun. Le moteur électrique 112 est destiné à fournir 500 kW de puissance mécanique. Pour cela, chaque voie fournit 250 kW de puissance électrique (83,3 kW par onduleur de cette voie).

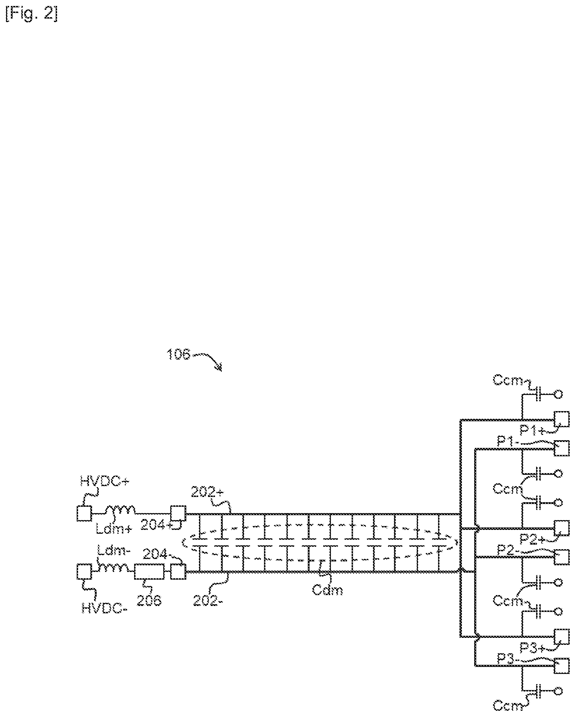

En référence à la figure 2, un des filtres d'entrée 106₁₋₃, 106*₁₋₃ va à présent être décrit plus en détail. Il sera désigné dans les figures 2 à 6 simplement par la référence 106, l'onduleur auquel ce filtre d'entrée 106 appartient sera désigné simplement par la référence 104, et les modules de puissance connectés à ce filtre seront désignés simplement par la référence 108.

Le filtre d'entrée 106 comporte tout d'abord une borne d'entrée positive HVDC+ et une borne d'entrée négative HVDC- conçue pour recevoir la tension continue U.

Le filtre d'entrée 106 comporte en outre deux inductances de mode différentiel Ldm+, Ldm- respectivement connectées aux bornes d'entrée HVDC+, HVDC-.

Le filtre d'entrée 106 comporte en outre une barre omnibus positive 202+ et une barre omnibus négative 202-, présentant respectivement une borne intermédiaire positive 204+ et une borne intermédiaire négative 204- respectivement connectées aux inductances de mode différentiel Ldm+, Ldm-.

Les inductances de mode différentiel Ldm+, Ldm- ont une valeur permettant d'assurer une stabilité réseau afin de rendre indépendant la résonance du filtre 106 à la longueur de câble (dans la mesure du possible). Par exemple, chaque inductance de mode différentiel Ldm+, Ldm- vaut entre 2 et 3 µH, par exemple 2.5 µH.

La barre omnibus positive 202+ présente en outre au moins une borne de sortie positive P1+, P2+, P3+, en particulier une pour chaque module de puissance 108.

De manière similaire, la barre omnibus négative 202- présente au moins une borne de sortie négative P1-, P2-, P3-, en particulier une pour chacun des modules de puissance 108 associés à ce filtre d'entrée 106.

Les barres omnibus 202+, 202- sont des conducteurs électriques rigides et de préférence laminés de manière à réduire l'inductance de boucle de commutation. La réduction de l'inductance de boucle de commutation est importante lors de l'utilisation de composants de puissance afin de réduire les pertes liées à la commutation des modules de puissance 108 et d'éviter les surtensions en entrée moteur électrique 112.

Le filtre d'entrée 106 comporte en outre en outre plusieurs capacités de mode différentiel Cdm connectées entre les barres omnibus 202+, 202-. Le nombre de capacités de mode différentiel Cdm est de préférence élevé, pour permettre leur répartition, comme cela sera expliqué par la suite. De préférence, leur nombre est d'au moins dix.

Ces capacités de mode différentiel Cdm présentent ensemble une valeur de capacité choisie de telle sorte à réduire la variation de la tension continue U et à assurer une qualité réseau suffisante pour supporter les courants de l'onduleur 104. Par exemple, la capacité équivalente est comprise entre 100 et 200 µF. Par exemple, chaque capacité a pour valeur 12.6 µF pour un total de 151 µF pour douze capacités de mode différentiel Cdm en parallèle.

Les capacités de mode différentiel Cdm utilisées sont de préférence des capacités de type polypropylène dont la durée de vie est dépendante du niveau de tension et de la température. Dans un équipement de puissance, la durée de vie est souvent donnée par la durée de vie des capacités utilisées. Ainsi, pour augmenter ou garantir une durée de vie longue, il est préférable d'optimiser le refroidissement des capacités de mode différentiel Cdm.

Le filtre d'entrée 106 comporte en outre, pour chaque borne de sortie, une capacité de mode commun Cdm connectée à la barre omnibus à laquelle cette borne de sortie appartient.

Le filtre d'entrée 106 comporte en outre un dispositif de mesure de courant dans au moins une des barres omnibus 202+, 202-. Dans l'exemple décrit, le dispositif de mesure de courant est conçu pour mesurer le courant passant dans la barre omnibus négative 202- et comporte par exemple une résistance 206.

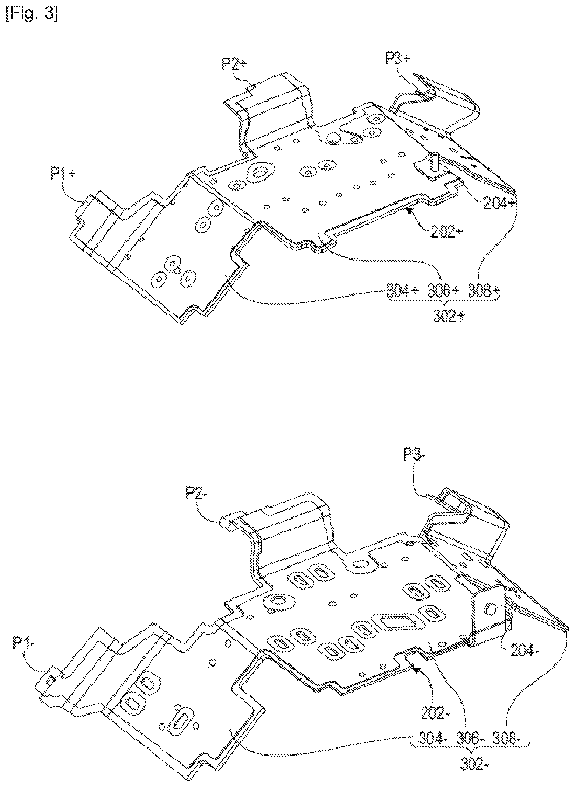

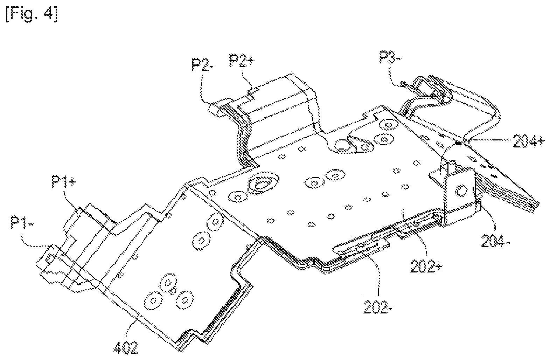

En référence aux figures 3 et 4, les barres omnibus 202+, 202- vont à présent être décrites plus en détail.

Les barres omnibus 202+, 202- comportent respectivement deux portions 302+, 302- ayant chacune une forme incurvée, dans un seul sens de courbure, et conçues pour s'emboîter l'une dans l'autre de manière à s'étendre à distance sensiblement constante l'une de l'autre.

Dans l'exemple illustré, la barre omnibus négative 202- vient s'emboiter dans la barre omnibus positive 202+. Ainsi, la barre omnibus positive 202+ sera qualifiée par la suite d'externe, tandis que la barre omnibus négative 202- sera qualifiée par la suite d'interne. Bien sûr, dans d'autres modes de réalisation, la barre omnibus négative 202- pourrait être externe et la barre omnibus positive 202+ pourrait être interne.

La courbure des portions 302+, 302- est obtenue par le fait que chaque portion 302+, 302- présente des pliures sensiblement parallèles afin de définir des plans se succédant l'un après l'autre en étant inclinés l'un par rapport au suivant, l'inclinaison étant toujours dans le même sens (pas de zigzag). Dans l'exemple illustré, chaque portion 302+, 302- comporte trois plans inclinés 304+, 306+, 308+ et 304-, 306-, 308-.

Une fois les barres omnibus 202+, 202- emboîtée l'une dans l'autre, chaque plan de l'une des barres omnibus 202+, 202- s'étend sensiblement parallèlement en face d'un plan associé de l'autre des barres omnibus 202+, 202-. Plus précisément, dans l'exemple illustré, les plans 304+, 304- s'étendent l'un en face de l'autre, de même que les plans 306+, 306- et les plans 308+, 308-.

Les barres omnibus 202+, 202- sont de préférence recouvertes d'un film isolant électrique 402 représenté en transparence sur la figure 4.

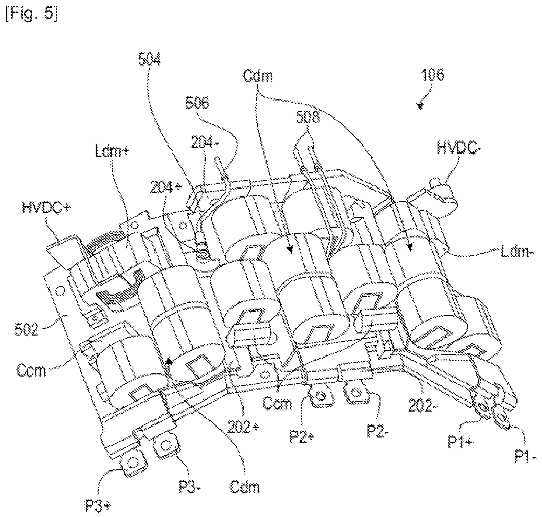

En référence à la figure 5, les capacités de mode différentiel Cdm sont connectées entre les deux portions 302+, 302- des barres omnibus 202+, 202-. De préférence, les capacités de mode différentiel Cdm sont disposées sur une face externe de la barre omnibus externe et/ou sur une face interne de la barre omnibus interne. Dans l'exemple illustré, toutes les capacités de mode différentiel sont disposées sur la face externe de la barre omnibus positive 202+.

En particulier, chaque paire de plans en vis-à-vis des barres omnibus 202+, 202- porte au moins deux capacités de mode différentiel Cdm. De préférence, la paire centrale de plans (les plans 306+, 306- dans l'exemple illustré) porte plus de capacités de mode différentiel Cdm que les paires périphériques de plans (les plans 304+, 304- et 308+, 308- dans l'exemple décrit).

Ainsi, dans l'exemple illustré, la paire de plans 306+, 306- porte six capacités de mode différentiel Cdm, tandis que chacune des paires de plans 304+, 304- et 308+, 308- porte trois capacités de mode différentiel Cdm.

En outre, le filtre d'entrée 106 comporte de préférence une plaque de base 502 portant les plaque omnibus 202+, 202-. La plaque de base 502 est en particulier elle-même incurvée pour s'emboiter dans la barre omnibus interne et s'étendre à distance sensiblement constante de cette dernière. Ainsi, dans l'exemple illustré, la plaque de base 502 comporte trois plans s'étendant respectivement parallèlement en face des plans 304+, 306+, 308+ de la barre omnibus négative 202-.

Les inductances de mode différentiel Ldm+, Ldm- sont par exemple portées par la plaque de base 502. De préférence, une interface thermique est prévue entre chaque inductance de mode différentiel Ldm+, Ldm- et la plaque de base 502 pour optimiser le refroidissement vers la plaque de base 502.

Le filtre d'entrée 106 peut en outre comporter, porté par les barres omnibus 202+, 202- et/ou par la plaque de base 502, un dispositif 504 de mesure de la tension U et un connecteur 506 pour transmettre la mesure de tension.

Le filtre d'entrée 106 peut en outre comporter un dispositif (non visible) de mesure d'une température du filtre d'entrée 106, en particulier d'une température d'une des capacités de mode différentiel Cdm et des connecteurs 508 pour transmettre la mesure de température.

Par exemple, la résistance 206 permettant la mesure de courant comporte un shunt de courant 510 présentant deux picots 512 entre lesquels une tension est mesurée pour en déduire le courant.

Tout ou partie de ces mesures est envoyé à l'électronique de commande 110 des modules de puissance 108, afin d'être utilisé pour la commande des interrupteurs des modules de puissance 108. Pour cela, l'électronique de commande 110 comporte par exemple un module de traitement et de numérisation des mesures, ce module de traitement recevant les connecteurs 506, 508 et les picots 512.

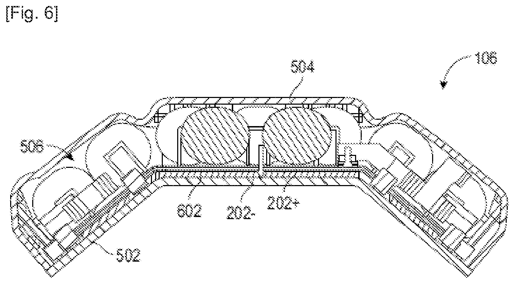

En référence à la figure 6, une couche isolante électrique 602 est prévue entre la barre omnibus interne (la barre omnibus négative 202- dans l'exemple décrit) et la plaque de base 502.

La couche isolante électrique 602 doit de préférence permettre de tenir 1 000 V sous toutes les conditions d'altitude et température rencontrées par l'aéronef, entre les deux barres omnibus 202+, 202- et la plaque de base 502 formant une masse électrique.

Le filtre d'entrée 106 comporte en outre un boîtier 504 venant au contact de la plaque de base 502 et recouvrant les capacités de mode différentiel Cdm, ainsi que par exemple les inductances de mode différentiel Ldm et/ou les capacités de mode commun Ccm. Le boîtier 504 est par exemple rempli d'un matériau isolant thermique 506, tel qu'une résine, afin que la chaleur dégagée par les capacités de mode différentiel Cdm et les inductances de mode différentiel Ccm s'évacue vers les barres omnibus 202+, 202- puis par la plaque de base 502. Ainsi, grâce au matériau isolant thermique 506, un transfert de chaleur direct entre les inductances de mode différentiel Ldm et les capacités de mode différentiel Cdm est limité. En effet, les inductances de mode différentiel Ldm chauffent en général beaucoup plus que les capacités de mode différentiel Cdm, ces dernières ne supportant en outre généralement pas une température très élevée. Ainsi, il est possible de placer ces composants proches les uns des autres, et obtenir ainsi une bonne compacité, sans que les composants chauffant beaucoup viennent élever la température des composants chauffant moins et ne supportant pas une température trop élevée. Par exemple, le matériau isolant thermique 506 présente une conductivité thermique inférieure à 0,5 W/m/K.

En outre, en cas de problème sur un composant, le matériau isolant thermique 506 est conçu pour contenir une explosion de ce composant.

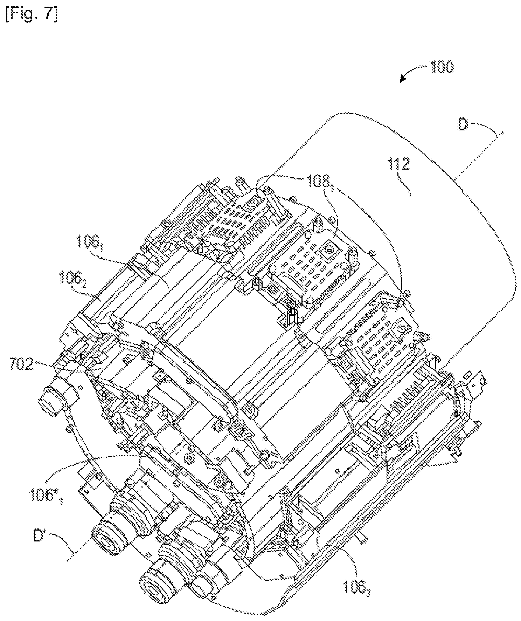

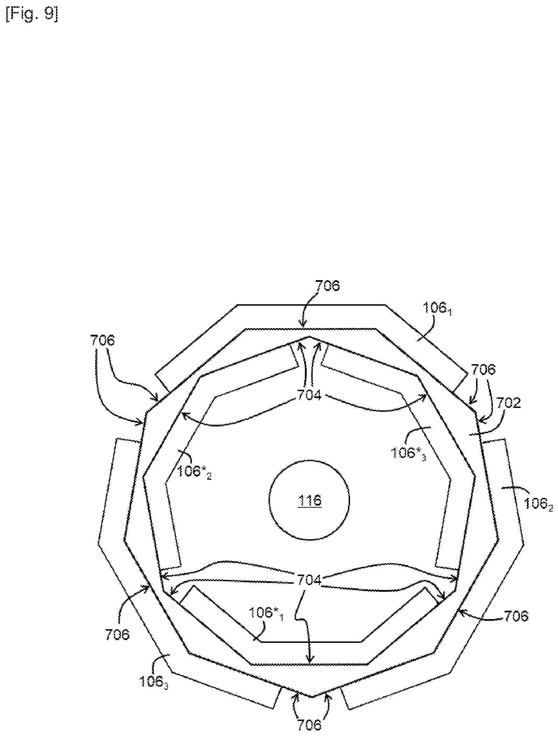

En référence aux figures 7 à 9, un exemple d'intégration de la propulsion électrique 100 va à présent être décrit.

Dans cet exemple, chaque voie de transmission de puissance comporte trois onduleurs 104₁₋₃, 104*₁₋₃. Ainsi, la propulsion électrique 100 comporte six filtres d'entrée 106₁₋₃, 106*₁₋₃.

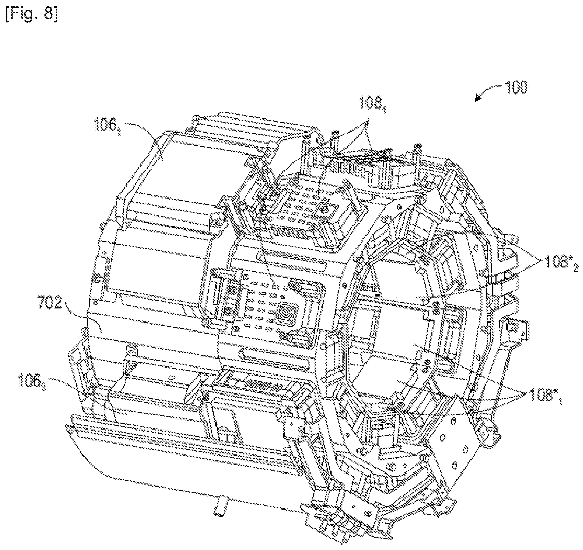

L'arbre de sortie 116 (non représenté sur les figures 7 et 8) solidaire du rotor du moteur électrique 112 s'étend selon un axe de rotation DD'.

La propulsion électrique 100 comporte un carter 702 entourant l'arbre de sortie 116 et présentant plusieurs faces planes, internes 704 et externes 706, se succédant autour de l'arbre de sortie 116. De préférence, les faces internes 704 et externes 706 sont de même nombre et sensiblement décalées angulairement autour de l'axe de rotation DD' d'une demi face plane. Dans l'exemple illustré, le carter 702 présente neuf faces planes internes 704 et neuf face planes externes.

Les filtres d'entrée 106₁₋₃, 106₁₋₃* sont répartis autour de l'axe de rotation DD' avec leur courbure autour de l'axe de rotation DD'. Plus précisément, dans l'exemple illustré, les filtres d'entrée 106₁₋₃ de la première voie sont plaqués contre les faces externes 706, tandis que les filtres d'entrée 106*₁₋₃ de la deuxième voie sont plaqués contre les faces internes 704. Ainsi, chaque filtre d'entrée 106₁₋₃, 106*₁₋₃ est plaqué contre des faces planes 704 ou 706 du carter 702 de manière à ce que chaque plaque de base 502 (et donc chaque plan de la portion de la barre omnibus inférieure) s'étende sensiblement parallèlement en face d'une face plane associée du carter 702.

De manière similaire, les modules de puissance 108₁₋₃, 108₁₋₃* sont par exemple répartis autour de l'axe de rotation DD' et placés entre les filtres d'entrée 106₁₋₃, 106₁₋₃* et le moteur électrique 112. Plus précisément, chaque module de puissance 108₁₋₃, 108*₁₋₃ est plaqué contre une face place, interne 704 ou externe 706, du carter 702, en particulier sur une des faces planes sur lesquelles est plaqué le filtre d'entrée 106₁₋₃, 106₁₋₃* de ce module de puissance 108₁₋₃, 108₁₋₃*. Le décalage angulaire entre les faces internes 704 et les faces externes 706 permet de placer les modules de puissance 108₁₋₃, 108₁₋₃* en série les uns à la suite des autres le long d'un même circuit de refroidissement, ce dernier refroidissant en alternance un module de puissance 108₁₋₃* d'une face interne 704, puis celui d'une face externe 706, et ainsi de suite.

Ainsi, les filtres d'entrée 106₁₋₃, 106₁₋₃* sont intégrés de manière compacte dans un volume restreint et arrondi. En outre, la longueur des harnais polyphasés 113₁₋₃, 113₁₋₃* est très réduite, ce qui permet de réduire les inductances parasites entre les capacités de mode différentiel Cdm et les modules de puissance 108₁₋₃, 108*₁₋₃.

Ainsi, la dissipation de la chaleur vers le carter 702 est favorisée par le fait que les barres omnibus 202+, 202- sont plaquées sur le carter 702 (au travers de la plaque de base 502 dans l'exemple décrit) sur une grande surface, du fait de leur forme incurvée complémentaire de celle du carter 702.

On notera que l'invention n'est pas limitée aux modes de réalisation décrits précédemment.

En particulier, le filtre d'entrée pourrait être purement capacitif et ne pas comporter les inductances de mode différentiel.

Dans la présentation détaillée de l'invention qui est faite précédemment, les termes utilisés ne doivent pas être interprétés comme limitant l'invention aux modes de réalisation exposés dans la présente description.

## Revendications

1. Propulsion électrique (100) comportant :
- un moteur électrique (112) ;
- plusieurs onduleurs (104₁₋₃, 104*₁₋₃) du moteur électrique (112), conçus pour convertir chacun une même tension continue (U) en une tension alternative polyphasée (V₁₋₃) respective, chaque onduleur (104₁₋₃, 104*₁₋₃) comportant :
• un filtre d'entrée (106₁₋₃ ; 106*₁₋₃ ; 106) conçu pour filtrer la tension continue (U), comportant :
▪ une barre omnibus positive (202+) et une barre omnibus négative (202-) ; et
▪ des capacités de mode différentiel (Cdm) connectées entre deux portions (302+, 302-) respectives des barres omnibus (202+, 202-) ;
les deux portions (302+, 302-) ayant chacune des pliures sensiblement parallèles afin de définir au moins trois plans (304+, 306+, 308+, 304-, 306-, 308-) se succédant l'un après l'autre en étant inclinés l'un par rapport au suivant, pour obtenir une courbure des portions (302+, 302-) ;
l'une des portions (302+, 302-), dite interne, étant emboîtée dans l'autre, dite externe, de manière à ce que chaque plan de l'une s'étende sensiblement parallèlement en face d'un plan associé de l'autre ; et
• des modules de puissance (108₁₋₃) conçus pour respectivement fournir les phases de la tension alternative polyphasée (V₁₋₃) à partir de la tension continue (U) après filtrage par le filtre d'entrée (106₁₋₃ ; 106*₁₋₃ ; 106) ;
- un arbre de sortie (116) solidaire d'un rotor du moteur électrique (112), les filtres d'entrée (106₁₋₃ ; 106*₁₋₃ ; 106) étant répartis autour d'un axe de rotation (DD') de l'arbre de sortie (116), avec leur courbure autour de l'axe de rotation (DD').

2. Propulsion électrique (100) selon la revendication 1, dans lequel plus de capacités de mode différentiel (Cdm) sont connectées entre la ou les paires centrales de plans (306+, 306-) qu'entre les deux paires périphériques de plans (304+, 304-, 308+, 308-).

3. Propulsion électrique (100) selon la revendication 1 ou 2, dans lequel les capacités de mode différentiel (Cdm) sont disposées sur une face externe de la portion (302+) externe et/ou sur une face interne de la portion (302-) interne.

4. Propulsion électrique (100) selon l'une quelconque des revendications 1 à 3, comportant en outre un carter (702) entourant l'arbre de sortie (116) et présentant plusieurs faces planes, internes (704) ou externes (706), se succédant autour de l'arbre de sortie (116), le filtre d'entrée étant plaqué contre les faces planes (704, 706) du carter (702) de manière à ce que chaque plan de la portion inférieure s'étende sensiblement parallèlement en face d'une face plane associée du carter (702).

5. Aéronef comportant une propulsion électrique (100) selon l'une quelconque des revendications 1 à 4.

## Patentansprüche

1. Elektroantrieb (100), umfassend:
- einen Elektromotor (112);
- mehrere Wechselrichter (104₁₋₃, 104*₁₋₃) für den Elektromotor (112), die dazu ausgelegt sind, jeweils eine gleiche Gleichspannung (U) in eine jeweilige mehrphasige Wechselspannung (V₁₋₃) umzuwandeln, wobei jeder Wechselrichter (104₁₋₃,104*₁₋₃) umfasst:
- ein Eingangsfilter (106₁₋₃;106*₁₋₃;106), das dazu ausgelegt ist, die Gleichspannung (U) zu filtern, umfassend:
- eine positive Sammelschiene (202+) und eine negative Sammelschiene (202-); und
- Gegentaktkapazitäten (Cdm), die zwischen zwei jeweilige Abschnitte (302+, 302-) der Sammelschienen (202+, 202-) geschaltet sind;
wobei die zwei Abschnitte (302+, 302-) jeweils im Wesentlichen parallele Biegungen aufweisen, um mindestens drei aufeinanderfolgende Ebenen (304+, 306+, 308+, 304-, 306-, 308-) zu definieren, die in Bezug zueinander geneigt sind, um eine Krümmung der Abschnitte (302+, 302-) zu erhalten;
wobei einer der Abschnitte (302+, 302-), der als innerer Abschnitt bezeichnet wird, in den anderen, als äußerer Abschnitt bezeichneten so verschachtelt ist, dass sich jede Ebene des einen im Wesentlichen parallel einer zugehörigen Ebene des anderen gegenüberliegend erstreckt; und
- Leistungsmodule (108₁₋₃), die dazu ausgelegt sind, auf Grundlage der Gleichspannung (U) nach Filterung durch das Eingangsfilter (106₁₋₃;106*₁₋₃; 106) jeweils die Phasen der mehrphasigen Wechselspannung ( V₁₋₃ ) bereitzustellen;
- eine Abtriebswelle (116), die fest mit einem Rotor des Elektromotors (112) verbunden ist, wobei die Eingangsfilter (106₁₋₃;106*₁₋₃;106) um eine Drehachse (DD') der Abtriebswelle (116) herum verteilt sind und ihre Krümmung um die Drehachse (DD') ausgerichtet ist.

2. Elektroantrieb (100) nach Anspruch 1, wobei zwischen das oder die mittleren Ebenenpaare (306+, 306-) mehr Gegentaktkapazitäten (Cdm) geschaltet sind als zwischen die zwei peripheren Ebenenpaare (304+, 304-, 308+, 308-).

3. Elektroantrieb (100) nach Anspruch 1 oder 2, wobei die Gegentaktkapazitäten (Cdm) an einer Außenseite des äußeren Abschnitts (302+) und/oder an einer Innenseite des inneren Abschnitts (302-) angeordnet sind.

4. Elektroantrieb (100) nach einem der Ansprüche 1 bis 3, der weiter ein Gehäuse (702) umfasst, das die Abtriebswelle (116) umgibt und mehrere innere (704) oder äußere (706) ebene Seiten aufweist, die um die Abtriebswelle (116) herum aufeinanderfolgen, wobei das Eingangsfilter so an den ebenen Seiten (704, 706) des Gehäuses (702) anliegt, dass sich jede Ebene des unteren Abschnitts im Wesentlichen parallel einer zugehörigen ebenen Seite des Gehäuses (702) gegenüberliegend erstreckt.

5. Luftfahrzeug, das einen Elektroantrieb (100) nach einem der Ansprüche 1 bis 4 umfasst.

## Claims

1. An electric drive (100) comprising:
- an electric motor (112);
- a plurality of inverters (104₁₋₃, 104*₁₋₃) for the electric motor (112), each designed to convert a common DC voltage (U) into a respective polyphase AC voltage (V₁₋₃), each inverter (104₁₋₃, 104*₁₋₃) comprising:
• an input filter (106₁₋₃; 106*₁₋₃; 106) designed to filter the DC voltage (U), comprising:
▪ a positive busbar (202+) and a negative busbar (202-); and
▪ differential-mode capacitors (Cdm) connected between two respective portions (302+, 302-) of the busbars (202+, 202-);
the two portions (302+, 302-) each having substantially parallel bends so as to define at least three planes (304+, 306+, 308+, 304-, 306-, 308-) following one after the other being inclined relative to the next, to obtain a curvature of the portions (302+, 302-);
one of the portions (302+, 302-), referred to as the inner portion, being nested within the other, referred to as the outer portion, such that each plane of the former extends substantially parallel to and opposite an associated plane of the latter; and
• power modules (108₁₋₃) designed to respectively supply the phases of the polyphase AC voltage (V₁₋₃) from the DC voltage (U) after filtering by the input filter (106₁₋₃; 106*₁₋₃; 106);
- an output shaft (116) integral with a rotor of the electric motor (112), the input filters (106₁₋₃; 106*₁₋₃; 106) being distributed around a rotation axis (DD') of the output shaft (116), with their curvature around the rotation axis (DD').

2. The electric drive (100) according to claim 1, wherein more differential mode capacitors (Cdm) are connected between the central pair or pairs of planes (306+, 306-) than between the two peripheral pairs of planes (304+, 304-, 308+, 308-).

3. The electric drive (100) according to claim 1 or 2, wherein the differential mode capacitors (Cdm) are arranged on an outer face of the outer portion (302+) and/or on an inner face of the inner portion (302-).

4. The electric drive (100) according to any one of claims 1 to 3, further comprising a casing (702) surrounding the output shaft (116) and having a plurality of planar faces, inner (704) or outer (706), arranged in succession around the output shaft (116), the inlet filter being pressed against the planar faces (704, 706) of the casing (702) such that each plane of the lower portion extends substantially parallel to and opposite an associated planar face of the casing (702).

5. An aircraft comprising an electric drive (100) according to any one of claims 1 to 4.
